# EUROPEAN PATENT SPECIFICATION

(11) **EP 3 943 564 B1**
(45) Date of publication and mention of the grant of the patent: **17.07.2024**
(21) Application number: 20186891.6
(22) Date of filing: 21.07.2020
(51) Int. Cl.: C09J 9/02, C09J 163/00, H01B 1/22

(54) **ROOM TEMPERATURE STABLE, ELECTRICALLY CONDUCTIVE 1K EPOXY FORMULATION**
BEI RAUMTEMPERATUR STABILE, ELEKTRISCH LEITFÄHIGE 1K-EPOXIDFORMULIERUNG
FORMULATION ÉPOXY 1K ÉLECTRIQUEMENT CONDUCTRICE STABLE À TEMPÉRATURE AMBIANTE

(43) Date of publication of application: 26.01.2022
(73) Proprietor: Henkel AG & Co. KGaA, 40589 Düsseldorf (DE)
(72) Inventor: Poeller, Sascha, 47057 Duisburg (DE); Wucherpfennig, Sven, 41542 Dormagen (DE); Estruga Ortiga, Marc, 3500 Hasselt / Limburg (BE); Henckens, Anja, 3520 Zonhoven (BE)

(56) References cited:
- US-A1- 2019 016 930
- US-A1- 2019 119 533
- US-A1- 2019 194 502

## Description

### TECHNICAL FIELD

The present invention relates to an electrically conductive, room temperature stable one-component (1K) epoxy adhesive compositions comprising electrically conductive particles and inorganic particles selected from the group consisting of barium sulphate, magnesium hydroxide, aluminium hydroxide and mixtures thereof. The electrically conductive adhesive compositions have particular utility in attaching solar cells together in a shingled photovoltaic module.

### TECHNICAL BACKGROUND

A solar cell or a photovoltaic cell is an electrical device that converts the energy of light directly into electricity by the photovoltaic effect. Solar cells are the building blocks of the photovoltaic modules, otherwise known as solar panels.

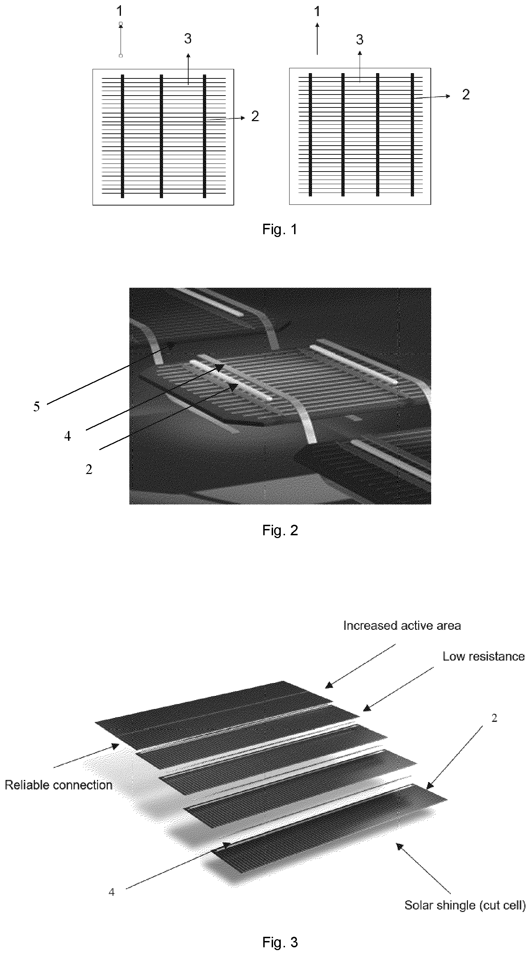

As illustrated in Figure 1 appended hereto, most of the solar cells (1) produced today consist of crystalline silicon wafers on which metallic contacts - busbars (2) and fingers (3) - are both printed, which serve to collect the current generated by the cell. For illustrative purposes only, Figure 1a illustrates a basic solar cell configuration with three busbars (2) and Figure 1 b illustrates a basic solar cell configuration with four busbars (2).

The array of straight, parallel and equally spaced thin fingers (3) covers a small portion of the light receiving surface of each individual silicon solar cell (1). These finger lines (3) reduce the resistance to the photoelectric current and provide lower current losses. Further, the finger lines (3) collect the current from the silicon solar cell surface and transfer it to tabbing ribbons (5) - as illustrated in Figure 2 appended hereto - through the busbars (2), which busbars are electric current conducting lines. The busbars (2) are disposed parallel to each other, are equally spaced and are orthogonal to the finger lines (3) array. The tabbing ribbon (5) is soldered to the surface of the busbars and facilitates transfer of the electric current from the connected silicon solar cells onwards to another silicon solar cell, to an accumulator or to a solar inverter.

Both busbars (2) and finger lines (3) are conventionally comprised of either high-temperature firing pastes or low temperature, non-firing type pastes - for heat sensitive solar cells, such as heterojunction (HJT or HIT) or tandem (perovskite-based) solar cells - and are usually realized by a one or two-stage printing process, which lays down these metallic contacts across and along the solar cell: the use of two successive printing stages facilitates the use of different materials for the busbars and finger lines respectively and also reflects the need to print busbars at a width thinner than finger lines. When printing the front side grid in two successive stages, typically, the finger lines (3) are printed and dried first and the busbars (2) are printed over the finger lines. While a single print step would result in similar heights of the busbar and the finger lines, in two-stage printing, in order to have secured contact between the finger lines and the busbars, and due to possible miss-alignment between the two patterns, there is a need for an overlap between the two patterns. In the overlap areas of the finger lines and busbars the height will be different than in the area where finger lines or busbars only are printed.

When the ribbons (5) are attached to the busbars (2) by means of a soldering process, those ribbons (5) are thus disposed on top of the busbars and - where disposed on the front of solar cells - cause a shadow area to extend over the solar cell: this shadow, concomitantly with the surface area of the solar cell actually covered by the busbars themselves, leads to a decrease in the efficiency of the photovoltaic module.

Further problems associated with such solar cell structures include: resistive losses resultant from a high current passing through ribbons (5) of small cross-section; differential thermal contraction of the ribbons (5) and the silicon wafer which can result in high stress in the metallization and silicon; and, stress and micro-cracks in the silicon wafer caused by the local effects of heat and pressure in the soldering process, which effects stymie the development of thinner wafers.

As a consequence of these problems, new solar module concepts have been developed which make use of new interconnection technologies and new solar cell types: by way of example, note may be made of multiwire interconnection on busbarless cells and conductive backsheet interconnection with back-contact cells. The present invention is however more particularly concerned both with the use of conductive adhesives in place of soldering and with series connected cells module structures, especially with shingled cells module structures.

In the shingled cells module structure shown Figure 3, solar strips are presented which are rectangular or substantially rectangular in shape. The long side usually has a length corresponding to the side length of a standard solar wafer - historically 156 mm but presently up to 210 mm - and the short side has a length of only a few centimeters. Such solar cell strips (21) have been cut out or diced from a processed device of standard size - such as, but not limited to, a 156 mm x 156 mm device - with due care taken to avoid cracks and like structural failures during the cutting or dicing process. The cells have busbars or rows of solder pads along the long edge, one on the front and one on the back. To create a cells string, an interconnection material is applied to connect the rear busbar of a cell with the front busbar of the next cell. The cells overlap each other slightly, so that the front busbars are covered by the edge region of the adjacent cell, just like shingles on a roof. Given that: i) there is no spacing between cells as compared to conventional modules; ii) the cell area that is shaded by the front busbar is covered by an active area of another cell; and, iii) there is no ribbon covering the cells' front surface to cause shading, this shingle structure results in modules with an extremely high active area (x) to total area ratio, allowing in principle very high module efficiency.

The adjacent cells in a given string are bonded to each other at the overlapping portions (y) of the solar cells with an electrically conductive material (4) which can be deposited in different patterns. Electrically conductive adhesive (ECA) as a material to bond the solar cells together presents the advantage that the adhesives overcome mechanical stresses which build up due to coefficient of thermal expansion (CTE) mismatches between the different materials used in a photovoltaic assembly.

Electrically conductive adhesives (ECA) are highly filled materials, typically characterized by having at least 40 wt.% and occasionally greater than 60 wt.% or even 80 wt.% of conductive filler particles, as required to ensure multiple percolation paths and provide good electrical conductivity and low contact resistance. Unfortunately, conductive filler particles do not provide reinforcing properties and do not contribute to material cohesion. As a result, an electrically conductive adhesive's intrinsic mechanical strength is much poorer than the same materials without filler.

The need for the polymer matrix to provide adequate shear strength is a first parameter which is determinative in the selection of an appropriate adhesive. Shear modulus (G, MPa) is a further determinant: within a shingled interconnection, the solar cells movement is much more constrained and the joints between the cells have to allow some movement by deformation while bearing some stress. Silicone electrically conductive adhesives are conventionally flexible (low G) but usually have lower shear strength. Epoxy-based electrically conductive adhesives, conversely, show a high shear strength but tend to be rather stiff (high G) which can lead to power output loss in the photovoltaic module when external stress is applied to it.

US2012/0177930 A1 (Henckens) describes an adhesive having utility in *inter alia* solar cells and solar modules, said adhesive comprising: a) at least one resin component which comprises i) at least one cyanate ester component and ii) at least one epoxy resin; b) at least one nitrogen-containing curative; c) at least one metal filler, which has a melting point of less than 300°C. at 1013 mbar; and, d) optionally, at least one electrically conductive filler, which is different from the metal filler.

US Patent No. 1 0,000,671 (Theunissen et al.) describes a thermally curable adhesive composition having utility in *inter alia* solar cells and solar modules, said adhesive comprising: a) at least one thermosetting resin selected from epoxy resins, benzoxazine resins, acrylate resins, bismaleimide resins, cyanate ester resins, polyisobutylene resins and/or combinations thereof; b) electrically conductive particles having an average particle size of 1 to 50 µm wherein the electrically conductive particles are present in the amount of 80 to 87 wt %, based on the total amount of the thermally curable adhesive; and, c) at least one silver precursor comprising reaction products of silver carboxylate and at least one primary or secondary amine-containing ligand, wherein the silver precursor has a decomposition temperature that is less than the cure temperature of the at least one thermosetting resin.

It will be recognized that photovoltaic modules are subjected to temperature changes and high mechanical stresses over their life cycle. Whilst these factors have a negative effect on the lifetime of the photovoltaic module, they also impose requirements on the thermo-mechanical properties of the electrically conductive adhesive used to bond the constituent solar and / or photovoltaic cells together: the adhesives should overcome mechanical stresses which build up due to coefficient of thermal expansion (CTE) mismatches between the different materials used in the photovoltaic assembly; and, the polymer matrix of the adhesive should desirably not pass through its glass transition temperature (Tg) within the operating range of the module such that it is in a glassy, brittle state at strongly negative temperatures (- 10 °C and below).

Aside from the properties of the obtained cured adhesive, the curing profile of the adhesive is also of great import. It is important that: the shelf life of the adhesive at room temperature is practicable; the cure time is practicable at a temperature which does not deleteriously effect the electronic components and metalized features; the adhesive is applicable - preferably dispensable or printable - and curable within an industrial process for high volume manufacturing; and, bleeding of the adhesive from the constituent joints is negligible.

### SUMMARY OF THE INVENTION

The present invention relates to an electrically conductive one component (1K) adhesive composition comprising:
a) epoxy resin;
b) at least one ionic constituent as a catalyst for epoxy homo-polymerization;
c) electrically conductive particles; and,
d) inorganic particles selected from the group consisting of barium sulphate, magnesium hydroxide, aluminium hydroxide, and mixtures thereof.
The composition is characterized by being stable at room temperature.

In an embodiment, the electrically conductive one component (1K) adhesive composition comprises, based on the weight of the composition:
from 20 to 55 wt.%, preferably from 25 to 40 wt.% of a) said epoxy resin;
from 0.5 to 5 wt.%, preferably from 0.6 to 4 wt.% of b) said at least one ionic constituent;
from 40 to 75 wt.%, preferably from 45 to 70 wt.% of c) said electrically conductive particles; and,
from 0.5 to 10 wt.%, preferably from 1 to 8 wt.% of d) said inorganic particles selected from the group consisting of barium sulphate, magnesium hydroxide, aluminium hydroxide, and mixtures thereof.

Said epoxy resin is preferably selected from the group consisting of: aliphatic epoxy resins; cycloaliphatic epoxy resins; epoxy novolac resins; bisphenol-A-epoxy resins; bisphenol-F-epoxy resins; bisphenol-A epichlorohydrin based epoxy resins; polyepoxides; reaction products of polyether-polyol with epichlorohydrin; epoxy silicone co-polymers; and, mixtures thereof. For example, said epoxy resin may be selected from bisphenol-A epichlorohydrin based epoxy resin, aliphatic epoxy resin and mixtures thereof.

Said ionic constituent b) is preferably constituted by at least one salt of a weakly coordinating anion and a cation selected from the group consisting of: ammonium; pyridinium; imidazolium; guadinium; oxazolium; thiazolium; iodinium; sulfonium; and, phosphonium. In accordance with the standard meaning of the term, an anion is weakly coordinating when its charge is delocalized over the entire surface of the anion rather than localized at a specific atom.

Without intention to be bound by theory, the presence of part d) said specific inorganic particles - homogeneously dispersed in the epoxy resin - serves at room temperature to inhibit the polymerization of the epoxy resin that would otherwise be initiated by the ionic constituent b).The epoxy resin in itself provides a low ionic strength medium. In that medium, at room temperature, the ionic constituent accumulates in the Helmholtz layer of the selected inorganic particles present. As a consequence of this, the cation-anion pair of the ionic constituent b) remain in close proximity within that layer, thereby reducing the cations activity towards other Lewis bases present in the medium.

When the temperature of the composition is elevated, the increased particulate diffusion within the composition is considered to diminish this co-ordinating of the catalyst b) around the introduced particles d). Given that the catalyst is not changed on a molecular level by this stabilization, the cure behavior - such as onset temperature - is not affected.

In accordance with a further aspect of the present invention, there is a provided a cured product of the electrically conductive composition as defined herein above and in the appended claims.

The present invention encompasses the use of the electrically conductive composition according to the present invention or the use of the cured product on a solar cell and / or in a photovoltaic module, preferably as an interconnection material to connect solar cells into a photovoltaic module.

The present invention also encompasses a photovoltaic module comprising a series-connected string of two or more solar cells in a shingle pattern having an electrically conductive bonding between said two or more solar cells, wherein said electrically conductive bonding is formed with an electrically conductive composition as defined hereinabove and in the appended claims or a series-connected string of two or more solar cells in a pattern having an electrically conductive ribbon connecting said two or more solar cells, wherein said electrically conductive ribbon is bonded to the cell with an electrically conductive composition as defined hereinabove and in the appended claims.

### BRIEF DESCRIPTION OF THE DRAWINGS

The background to the invention has been described with reference to the appended drawings in which:
Figure 1 illustrates a structure of a typical silicon solar cell;
Figure 2 illustrates a conventional photovoltaic module; and,
Figure 3 illustrates a shingled photovoltaic module.

### DEFINITIONS

In the following passages the present invention is described in more detail. Each aspect so described may be combined with any other aspect or aspects unless clearly indicated to the contrary. In particular, any feature indicated as being preferred or advantageous may be combined with any other feature or features indicated as being preferred or advantageous.

In the context of the present invention, the terms used are to be construed in accordance with the following definitions, unless a context dictates otherwise.

As used herein, the singular forms "a", *"an"* and *"the"* include both singular and plural referents unless the context clearly dictates otherwise.

The terms *"comprising", "comprises"* and *"comprised of"* as used herein are synonymous with *"including", "includes", "containing",* or *"contains",* and are inclusive or open-ended and do not exclude additional, non-recited members, elements or method steps.

As used herein, the term *"consisting of"* excludes any element, ingredient, member or method step not specified.

Further, in accordance with standard understanding, a weight range represented as being *"from 0 to* x" specifically includes 0 wt.%: the ingredient defined by said range may be absent from the composition or may be present in the composition in an amount up to x wt.%.

The words *"preferred", "preferably", "desirably"* and *"particularly"* are used frequently herein to refer to embodiments of the disclosure that may afford particular benefits, under certain circumstances. However, the recitation of one or more preferable, preferred, desirable or particular embodiments does not imply that other embodiments are not useful and is not intended to exclude those other embodiments from the scope of the disclosure.

As used throughout this application, the word *"may"* is used in a permissive sense - that is meaning to have the potential to - rather than in the mandatory sense.

The recitation of numerical end points includes all numbers and fractions subsumed within the respective ranges, as well as the recited end points.

When an amount, a concentration or other values or parameters is/are expressed in form of a range, a preferable range, or a preferable upper limit value and a preferable lower limit value, it should be understood as that any ranges obtained by combining any upper limit or preferable value with any lower limit or preferable value are specifically disclosed, without considering whether the obtained ranges are clearly mentioned in the context.

All percentages, parts, proportions and then like mentioned herein are based on weight unless otherwise indicated.

As used herein, *"shelf life"* refers to a time period when the composition of the invention maintains its original design intended properties, in particular its viscosity, without deteriorating or becoming unsuitable for use. As the composition thickens upon curing the increase in viscosity can be deleterious to its application, for example.

As used herein, the term *"equivalent (eq.")* relates, as is usual in chemical notation, to the relative number of reactive groups present in the reaction.

As used herein, the term *"epoxide"* denotes a compound characterized by the presence of at least one cyclic ether group, namely one wherein an ether oxygen atom is attached to two adjacent carbon atoms thereby forming a cyclic structure. The term is intended to encompass monoepoxide compounds, polyepoxide compounds (having two or more epoxide groups) and epoxide terminated prepolymers. The term *"monoepoxide compound"* is meant to denote epoxide compounds having one epoxy group. The term *"polyepoxide compound"* is meant to denote epoxide compounds having at least two epoxy groups. The term *"diepoxide compound"* is meant to denote epoxide compounds having two epoxy groups.

The epoxide may be unsubstituted but may also be inertly substituted. Exemplary inert substituents include chlorine, bromine, fluorine and phenyl.

As would be recognized by the skilled artisan, the term *"epoxy homo-polymerization"* refers to the reaction of epoxide compounds with each other: It does not preclude more than one monomer bearing epoxy group(s) from being present in the composition and these monomers reacting to form the cured epoxy resin. The term is however to be contrasted with epoxy hetero-polymerization, whereby epoxy molecules are linked together through the reactive sites of a curative, such as an amine.

As used herein, "*C₁-Cₙ alkyl"* group refers to a monovalent group that contains 1 to n carbons atoms, that is a radical of an alkane and includes straight-chain and branched organic groups. As such, a *"C₁-C₈ alkykl"* group refers to a monovalent group that contains from 1 to 8 carbons atoms, that is a radical of an alkane and includes straight-chain and branched organic groups. Examples of alkyl groups include, but are not limited to: methyl; ethyl; propyl; isopropyl; n-butyl; isobutyl; sec-butyl; tert-butyl; n-pentyl; n-hexyl; n-heptyl; and, 2-ethylhexyl. In the present invention, such alkyl groups may be unsubstituted or may be substituted with one or more substituents selected from halogen, hydroxy, nitrile (-CN), amido and amino (-NH₂). Where applicable, a preference for a given substituent will be noted in the specification.

The term *"C₃ -C₃₀ cycloalkyl"* is understood to mean an optionally substituted, saturated, mono-, bi- or tricyclic hydrocarbon group having from 3 to 30 carbon atoms. In general, a preference for cycloalkyl groups containing from 3-10 carbon atoms (C₃-C₁₈ cycloalkyl groups) should be noted. Examples of cycloalkyl groups include: cyclopropyl; cyclobutyl; cyclopentyl; cyclohexyl; cycloheptyl; cyclooctyl; adamantane; and, norbornane. In the present invention, such cycloalkyl groups may be unsubstituted or may be substituted with one or more substituents selected from halogen, C₁-C₆ alkyl and C₁-C₆ alkoxy.

As used herein, an *"C₆-C₁₈ aryl"* group used alone or as part of a larger moiety - as in *"aralkyl group"* - refers to optionally substituted, monocyclic, bicyclic and tricyclic ring systems in which the monocyclic ring system is aromatic or at least one of the rings in a bicyclic or tricyclic ring system is aromatic. The bicyclic and tricyclic ring systems include benzofused 2-3 membered carbocyclic rings. In the present invention, such aryl groups may be unsubstituted or may be substituted with one or more substituents selected from halogen, C₁-C₆ alkyl and C₁-C₆ alkoxy. Exemplary aryl groups include: phenyl; (C₁-C₄)alkoxyphenyl, such as methoxyphenyl; (C₁-C₄)alkylphenyl, such as tolyl and ethylphenyl; indenyl; naphthalenyl, tetrahydronaphthyl, tetrahydroindenyl; tetrahydroanthracenyl; and, anthracenyl. And a preference for phenyl groups may be noted.

As used herein, *"C₂-C₁₂ alkenyl"* refers to hydrocarbyl groups having from 2 to 12 carbon atoms and at least one unit of ethylenic unsaturation. The alkenyl group can be straight chained, branched or cyclic and may optionally be substituted. The term *"alkenyl"* also encompasses radicals having *"cis"* and *"trans"* configurations, or alternatively, "*E*" and "Z" configurations, as appreciated by those of ordinary skill in the art. In general, however, a preference for unsubstituted alkenyl groups containing from 2 to 10 (C₂₋₁₀) or 2 to 8 (C₂₋₈) carbon atoms should be noted. Examples of said C₂-C₁₂ alkenyl groups include, but are not limited to: -CH=CH₂; -CH=CHCH₃; -CH₂CH=CH₂; -C(=CH₂)(CH₃); -CH=CHCH₂CH₃; -CH₂CH=CHCH₃; -CH₂CH₂CH=CH₂; -CH=C(CH₃)₂; -CH₂C(=CH₂)(CH₃); -C(=CH₂)CH₂CH₃; -C(CH₃)=CHCH₃; -C(CH₃)CH=CH₂; -CH=CHCH₂CH₂CH₃; - CH₂CH=CHCH₂CH_{3;} -CH₂CH₂CH=CHCH₃; -CH₂CH₂CH₂CH=CH₂; -C(=CH₂)CH₂CH₂CH₃; - C(CH₃)=CHCH₂CH₃; -CH(CH₃)CH=CHCH_{;} -CH(CH₃)CH₂CH=CH₂; -CH₂CH=C(CH₃)₂; 1-cyclopent-1-enyl; 1-cyclopent-2-enyl; 1-cyclopent-3-enyl; 1-cyclohex-1-enyl; 1-cyclohex-2-enyl; and, 1-cyclohexyl-3-enyl.

As used herein, *"alkylaryl"* refers to alkyl-substituted aryl groups and *"substituted alkylaryl"* refers to alkylaryl groups further bearing one or more substituents as set forth above. Further, as used herein *"aralkyl"* means an alkyl group substituted with an aryl radical as defined above: exemplary aralkyl groups include benzyl, 4-methoxybenzyl and phenethyl.

As used herein *"iron oxide"* refers to any oxide of iron and encompasses FeO, Fe₂O₃, Fe₃O₄ and combinations thereof.

As used herein, *"room temperature"* denotes 23° ± 2°C.

All references cited in the present specification are hereby incorporated by reference in their entirety.

The electrically conductive composition has been defined hereinabove as having particular utility as a curable adhesive composition in solar cells and solar modules. It should be stated, however, that the composition may be claimed and may be afforded any or all feature(s) afforded to the composition but without limitation to use within / for adhering solar modules, solar cells and components thereof. The composition may, for instance, find utility in the adhesion of other electronic components and devices.

Unless otherwise defined, all terms used in disclosing the invention, including technical and scientific terms, have the meaning as commonly understood by one of the ordinary skill in the art to which this invention belongs to. By means of further guidance, term definitions are included to better appreciate the teaching of the present invention.

### DETAILED DESCRIPTION OF THE INVENTION

### Part a)

The composition of the present invention comprises epoxy resin which will typically be present in an amount of from 15 to 50 wt.%, based on the weight of said composition: it is preferred that the epoxy resin constitutes from 20 to 45 wt.%, for example from 25 to 40 wt.% or from 28 to 39 wt.% of said composition.

Epoxy resins as used herein may include mono-functional epoxy resins, multi- or poly-functional epoxy resins, and combinations thereof. The epoxy resins may be pure compounds but equally may be mixtures of epoxy functional compounds, including mixtures of compounds having different numbers of epoxy groups per molecule. An epoxy resin may be saturated or unsaturated, aliphatic, cycloaliphatic, aromatic or heterocyclic and may be substituted. Further, the epoxy resin may also be monomeric or polymeric.

Without intention to limit the present invention, illustrative monoepoxide compounds include: alkylene oxides; epoxy-substituted cycloaliphatic hydrocarbons, such as cyclohexene oxide, vinylcyclohexene monoxide, (+)-cis-limonene oxide, (+)-cis,trans-limonene oxide, (-)-cis,trans-limonene oxide, cyclooctene oxide, cyclododecene oxide and α-pinene oxide; epoxy-substituted aromatic hydrocarbons; monoepoxy substituted alkyl ethers of monohydric alcohols or phenols, such as the glycidyl ethers of aliphatic, cycloaliphatic and aromatic alcohols; monoepoxy-substituted alkyl esters of monocarboxylic acids, such as glycidyl esters of aliphatic, cycloaliphatic and aromatic monocarboxylic acids; monoepoxy-substituted alkyl esters of polycarboxylic acids wherein the other carboxy group(s) are esterified with alkanols; alkyl and alkenyl esters of epoxy-substituted monocarboxylic acids; epoxyalkyl ethers of polyhydric alcohols wherein the other OH group(s) are esterified or etherified with carboxylic acids or alcohols; and, monoesters of polyhydric alcohols and epoxy monocarboxylic acids, wherein the other OH group(s) are esterified or etherified with carboxylic acids or alcohols.

By way of example, the following glycidyl ethers might be mentioned as being particularly suitable monoepoxide compounds for use herein: methyl glycidyl ether; ethyl glycidyl ether; propyl glycidyl ether; butyl glycidyl ether; pentyl glycidyl ether; hexyl glycidyl ether; cyclohexyl glycidyl ether; octyl glycidyl ether; 2-ethylhexyl glycidyl ether; allyl glycidyl ether; benzyl glycidyl ether; phenyl glycidyl ether; 4-tert-butylphenyl glycidyl ether; 1-naphthyl glycidyl ether; 2-naphthyl glycidyl ether; 2-chlorophenyl glycidyl ether; 4-chlorophenyl glycidyl ether; 4-bromophenyl glycidyl ether; 2,4,6-trichlorophenyl glycidyl ether; 2,4,6-tribromophenyl glycidyl ether; pentafluorophenyl glycidyl ether; o-cresyl glycidyl ether; m-cresyl glycidyl ether; and, p-cresyl glycidyl ether.

In an embodiment, the monoepoxide compound conforms to Formula (I) herein below: 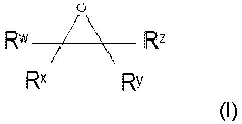 wherein: R^{w}, R^{x}, R^{y} and R^{z} may be the same or different and are independently selected from hydrogen, a halogen atom, a C₁-C₈ alkyl group, a C₃ to C₁₀ cycloalkyl group, a C₂-C₁₂ alkenyl, a C₆-C₁₈ aryl group or a C₇-C₁₈ aralkyl group, with the proviso that at least one of R^{y} and R^{z} is not hydrogen.

It is preferred that R^{w}, R^{x} and R^{y} are hydrogen and R^{z} is either a phenyl group or a C₁-C₈ alkyl group and, more preferably, a C₁-C₄ alkyl group.

Having regard to this embodiment, exemplary monoepoxides include: ethylene oxide; 1,2-propylene oxide (*propylene oxide*); 1,2-butylene oxide; cis-2,3-epoxybutane; trans-2,3-epoxybutane; 1,2-epoxypentane; 1,2-epoxyhexane; 1,2-heptylene oxide; decene oxide; butadiene oxide; isoprene oxide; and, styrene oxide.

In the present invention, reference is made to using at least one monoepoxide compound selected from the group consisting of: ethylene oxide; propylene oxide; cyclohexene oxide; (+)-cis-limonene oxide; (+)-cis,trans-limonene oxide; (-)-cis,trans-limonene oxide; cyclooctene oxide; and, cyclododecene oxide.

Again, without intention to limit the present invention, suitable polyepoxide compounds may be liquid, solid or in solution in solvent. Further, such polyepoxide compounds should have an epoxide equivalent weight of from 100 to 700 g/eq, for example from 100 to 350 g/eq. And generally, diepoxide compounds having epoxide equivalent weights of less than 500 g/eq. or even less than 400 g/eq. are preferred: this is predominantly from a costs standpoint, as in their production, lower molecular weight epoxy resins require more limited processing in purification.

As examples of types or groups of polyepoxide compounds which may be polymerized in the present invention, mention may be made of: glycidyl ethers of polyhydric alcohols and polyhydric phenols; glycidyl esters of polycarboxylic acids; and, epoxidized polyethylenically unsaturated hydrocarbons.

Suitable diglycidyl ether compounds may be aromatic, aliphatic or cycloaliphatic in nature and, as such, can be derivable from dihydric phenols and dihydric alcohols. And useful classes of such diglycidyl ethers are: diglycidyl ethers of aliphatic and cycloaliphatic diols, such as 1,2-ethanediol, 1,4-butanediol, 2,2-dimethyl-1,3-propanediol, 1,6-hexanediol, 1,8-octanediol, 1,12-dodecanediol, cyclopentane diol, cyclohexane diol, cyclohexane dimethanol; resorcinol diglycidyl ether; bisphenol A based diglycidylethers; bisphenol-A epichlorohydrin based epoxy resins; bisphenol F diglycidyl ethers; diglycidyl o-phthalate, diglycidyl isophthalate and diglycidyl terephthalate; polyalkyleneglycol based diglycidyl ethers, in particular polypropyleneglycol diglycidyl ethers; and, polycarbonatediol based glycidyl ethers. Other suitable diepoxides which might also be mentioned include: diepoxides of double unsaturated fatty acid C₁-C₁₈ alkyl esters; dimer acid diglycidyl esters; butadiene diepoxide; polybutadiene diglycidyl ether; vinylcyclohexene diepoxide; and, limonene diepoxide.

Further exemplary polyepoxide compounds having utility in the present invention include: diglycidyl ether; glycidyl glycidate; glycerol polyglycidyl ether; bis(2,3-epoxy-2-methylpropyl)ether; trimethylol ethane triglycidyl ether; trimethylolpropane polyglycidyl ether; pentaerythritol polyglycidyl ether; diglycerol polyglycidyl ether; polyglycerol polyglycidyl ether; sorbitol polyglycidyl ether; propoxylated glycerol polyglycidyl ether; polyglycidyl ether of castor oil; epoxidized propylene glycol dioleates; 1,2-tetradecane oxides; and, internally epoxidized 1,3-butadiene homopolymers.

And examples of highly preferred polyepoxide compounds include: flexibilizing epoxy resins available as Heloxy^{™} Modifier Numbers 32, 44, 56, 67, 68, 69, 71, 84, 107, and 505 available from Shell Chemical Company; epoxy novolac resins, such as resins of the EPIKOTE^{™} and EPON^{™} series available from Hexion and DEN^{™} 438 available from Dow Chemical Company; bisphenol-A epoxy resins, such as DER^{™} 331, and DER^{™} 383; bisphenol-F epoxy resins, such as DER^{™} 354; bisphenol-A/F epoxy resin blends, such as DER^{™} 353; aliphatic glycidyl ethers, such as DER^{™} 736; polypropylene glycol diglycidyl ethers, such as DER^{™} 732; solid bisphenol-A epoxy resins, such as DER^{™} 661 and DER^{™} 664 UE; solutions of bisphenol-A solid epoxy resins, such as DER^{™} 671-X75; castor oil triglycidyl ether, such as ERISYS^{™} GE-35H; polyglycerol-3-polyglycidyl ether, such as ERISYS^{™} GE-38; sorbitol glycidyl ether, such as ERISYS^{™} GE-60; and, Poly BD 600, Poly BD 650, Vikoflex^{™} 4050 and Vikoflex^{™} 5075 available from Elf Atochem.

The above aside, the composition can in certain embodiments comprise glycidoxy alkyl alkoxy silanes having the formula: 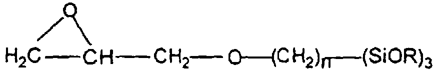 wherein: each R is independently selected from methyl or ethyl; and,
n is from 1-10.

Exemplary silanes include but are not limited to: γ-glycidoxy propyl trimethoxy silane, γ-glycidoxy ethyl trimethoxy silane, γ-glycidoxy methyl trimethoxy silane, γ-glycidoxy methyl triethoxy silane, γ-glycidoxy ethyl triethoxy silane, γ-glycidoxy propyl triethoxy silane; and, 8-glycidooxyoctyl trimethoxysilane. When present, the epoxide functional silanes should constitute less than less than 10 wt.%, preferably less than 5 wt.% or less than 2 wt.%, based on the total weight of the epoxide compounds.

The present invention also does not preclude the curable compositions from further comprising one or more cyclic monomers selected from the group consisting of: oxetanes; cyclic carbonates; cyclic anhydrides; and, lactones. The disclosures of the following citations may be instructive in disclosing suitable cyclic carbonate functional compounds: US Patent No. 3,535,342; US Patent No. 4,835,289; US Patent No. 4,892,954; UK Patent No. GB-A-1,485,925; and, EP-A-0 119 840. However, such cyclic co-monomers should constitute less than 10 wt.%, preferably less than 7.5 wt.% or less than 5 wt.%, based on the total weight of the epoxide compounds.

### b) Ionic constituent

The composition of the present invention comprises b) at least one ionic constituent which functions as a catalyst for epoxy homo-polymerization. The composition should typically be characterized by containing from 0.5 to 5% by weight of the total weight of the composition, preferably from 0.6 to 4%, more preferably from 0.7 to 3.75% and even more preferably from 0.75 to 3.5% of b) said at least one ionic constituent.

The ionic constituent (part b)) preferably comprises at least one salt having a formula selected from the group consisting of: 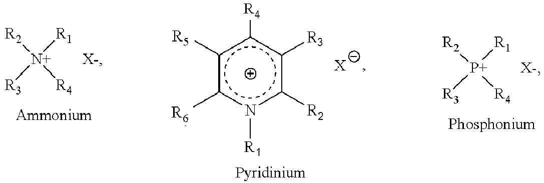 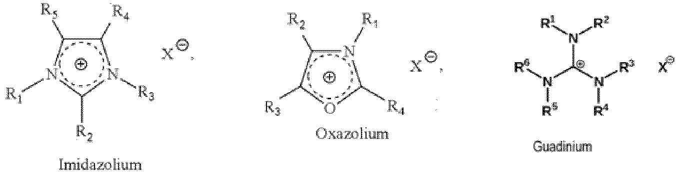 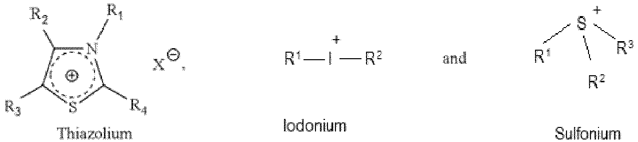 wherein: R¹, R², R³, R⁴, R⁵ and R⁶ are independently selected from hydrogen, C₁-C₁₈ alkyl, C₃-C₁₈ cycloalkyl, C₆-C₁₈ aryl, C₇-C₂₄ aralkyl, C₂-C₂₀ alkenyl, -C(O)R^{q}, -C(O)OH, -CN and -NO₂; and, R^{q} is C₁-C₆ alkyl.

For completeness, the terms C₁-C₁₈ alkyl, C₃-C₁₈ cycloalkyl, C₆-C₁₈ aryl, C₇-C₂₄ aralkyl, C₂-C₂₀ alkenyl expressly includes groups wherein one or more hydrogen atoms are substituted by halogen atoms (e.g. C₁-C₁₈ haloalkyl) or hydroxyl groups (e.g. C₁-C₁₈ hydroxyalkyl). In particular, it is preferred that R¹, R², R³, R⁴, R⁵ and R⁶ are independently selected from hydrogen, C₁-C₁₂ alkyl, C₃-C₁₂ cycloalkyl, C₆-C₁₈ aryl and C₇-C₂₄ aralkyl. For example, R¹, R², R³, R⁴, R⁵ and R⁶ may be independently selected from hydrogen, C₁-C₆ alkyl, C₁-C₆ haloalkyl, C₁-C₆ hydroxyalkyl, C₆-C₁₈ aryl and C₇-C₂₄ aralkyl.

There is no particular intention to limit the counter anion (X-) which may be present in the aforedescribed salt or salts of the ionic constituent b) but said anions should preferably be weakly co-ordinating.

Exemplary anions (X-) may be selected from: i) halogen-containing compounds of the formulae PF₆ ⁻, BF₄⁻, SbF₆⁻, AsF₆⁻, OTeF₅⁻, CF₃SO₃ ⁻, (CF₃SO₃)₂N⁻, OClO₃⁻, CF₃CO₂ ⁻ and CCl₃CO₂ ⁻; ii) pseudohalides such as CN⁻, SCN⁻ and OCN⁻; iii) phenates; iv) sulfates, sulfites and sulfonates of the general formulae SO₄ ²⁻, HSO₄ ⁻, SO₃ ²⁻, HSO₃ ⁻, R^{a}OSO₃ ⁻ and R^{a}SO₃ ⁻; v) phosphates of the general formulae POa ³⁻, HPO₄ ²⁻, H₂PO₄ ⁻, R^{a}POa ²⁻, HR^{a}PO₄ ⁻ and R^{a}R^{b}PO₄ ⁻; vi) phosphonates and phosphinates of the general formulae R^{a}HPO₃ ⁻,R^{a}R^{b}PO₂ ⁻ and R^{a}R^{b}PO₃ ⁻; vii) phosphites of the general formulae: PO₃ ³⁻, HPO₃ ²⁻, H₂PO₃ ⁻, R^{a}PO₃ ²⁻, R^{a}HPO₃ - and R^{a}R^{b}PO₃ ⁻; viii) phosphonites and phosphinites of the general formulae R^{a}R^{b}PO₂ ⁻, R^{a}HPO₂ ⁻, R^{a}R^{b}PO⁻ and R^{a}HPO⁻; ix) carboxylic acid anions of the general formula R^{a}COO⁻; x) hydroxycarboxylic acids anions and sugar acid anions; xi) saccharinates (salts of o-benzoic acid sulfimide); xii) aluminates of the general formula Al(OR^{a})(OR^{b})(OR^{c})(OR^{d})⁻; xiii) borates of the general formulae B(R^{a})(R^{b})(R^{c})(R^{d})^{-,} BO₃ ³⁻, HBO₃ ²⁻, H₂BO₃ ⁻, R^{a}R^{b}BO₃ ⁻, R^{a}HBO₃ ⁻, R^{a}BO₃ ²⁻, B(OR^{a})(OR^{b})(OR^{c})(OR^{d})⁻, B(HSO₄)⁻ and B(R^{a}SO₄)⁻; xiv) boronates of the general formulae R^{a}BO₂ ²⁻ and R^{a}R^{b}BO⁻; xv) carbonates and carbonic acid esters of the general formulae HCOs ⁻, CO₃ ²⁻ and R^{a}CO₃ ⁻; xvi) silicates and silicic acid esters of the general formulae SiO₄ ⁴⁻, HSiO₄ ³⁻, H₂SiO₄ ²⁻, H₃SiO₄ -, R^{a}SiO₄ ³⁻, R^{a}R^{b}SiO₄ ²⁻, R^{a}R^{b}R^{c}SiO₄⁻, HR^{a}SiO₄ ²⁻, H₂R^{a}SiO₄ ⁻ and HR^{a}R^{b}SiO₄ ⁻; xvii) alkyl- and arylsilanolates of the general formulae R^{a}SiO₃ ³⁻, R^{a}R^{b}SiO₂ ²⁻, R^{a}R^{b}R^{c}SiO⁻, R^{a}R^{b}R^{c}SiO₃ ⁻, R^{a}R^{b}R^{c}SiO₂ ⁻ and R^{a}R^{b}SiO₃ ²⁻; xviii) pyridinates and pyrimidinates; xix) alkoxides and aryloxides of the general formula R^{a}O⁻; xx) sulfides, hydrogen sulfides, polysulfides, hydrogen polysulfides and thiolates of the general formulae S²⁻, HS⁻, [Sᵥ]²⁻, [HSᵥ]⁻ and [R^{a}S]⁻; xxi) carboxylic acid imides, bis(sulfonyl)imides and sulfonylimides of the general formulae: 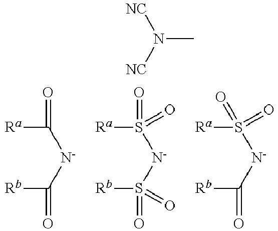 and, xxii) methides of the general formula: 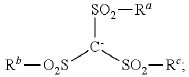 in which general formulae:
v is a whole positive number of from 2 to 10; and,
R^{a}, R^{b}, R^{c} and R^{d} are independently selected from hydrogen, a C₁-C₁₂ alkyl, C₅-C₁₂ cycloalkyl, C₅-C₁₂ heterocycloalkyl, C₆-C₁₈ aryl and C₅-C₁₈ heteroaryl.

In an embodiment, the anion (X-) of the ionic salt is in accordance with the general formula: 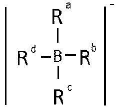 wherein: R^{a}, R^{b}, R^{c} and R^{d} are independently selected from hydrogen, C₁-C₁₂ alkyl, C₅-C₁₂ cycloalkyl, C₅-C₁₂ heterocycloalkyl, C₆-C₁₈ aryl and C₅-C₁₈ heteroaryl.

Preferably at least three of R^{a}, R^{b}, R^{c} and R^{d} in the borate moiety are the same. More preferably R^{a}, R^{b}, R^{c} and R^{d} are all the same and are selected from C₁-C₆ alkyl and phenyl. A particular preference is noted for anions selected from the group consisting of: tetraphenylborate; tetrakis[3,5-bis(trifluoromethyl)phenyl]borate; tetrakis(4-chlorophenyl)borate; tetrakis(4-fluorophenyl)borate; tetrakis(pentafluorophenyl)borate; and, tetrakis(pentachlorophenyl)borate.

In a further embodiment, the anion (X-) of the ionic salt is selected from the group consisting of: OClO₃⁻; PF₆ ⁻; BF₄⁻; SbF₆⁻; AsF₆⁻; trifluoromethanesulfonate (triflate); and, tetra(nonafluoro-tert-butoxy)aluminate.

Without intention to limit the present invention, part b) of the composition preferably comprises at least one compound selected from the group consisting of: tetraalkyl ammonium tetrafluoro borate; tetraalkyl ammonium hexafluorophosphate; tetraalkyl ammonium hexafluoroantimonate; tetraalkyl ammonium triflate; trialkyl sulfonium tetrafluoro borate; trialkyl sulfonium hexafluorophosphate; trialkyl sulfonium hexafluoroantimonate; trialkyl sulfonium triflate; triaryl sulfonium tetrafluoro borate; triaryl sulfonium hexafluorophosphate; triaryl sulfonium hexafluoroantimonate; triaryl sulfonium triflate; dialkyl iodonium tetrafluoro borate; dialkyl iodonium hexafluorophosphate; dialkyl iodonium hexafluoroantimonate; dialkyl iodonium triflate; diaryl iodonium tetrafluoro borate; diaryl iodonium hexafluorophosphate; diaryl iodonium hexafluoroantimonate; diaryl iodonium triflate; benzylammonium tetrafluoro borate; benzylammonium hexafluoro phosphate; benzylammonium hexafluoroantimonate; benzylammonium triflate; p-methoxybenzylanilinium tetrafluoro borate; p-methoxybenzylanilinium hexafluoro phosphate; p-methoxybenzylanilinium hexafluoroantimonate; and, p-methoxybenzylanilinium triflate.

Part b) of the composition more preferably comprises at least one compound selected from the group consisting of: N,N-dimethyl-N-(p-methoxybenzyl)anilinium tetrafluoroborate; N,N-dimethyl-N-(p-methoxybenzyl)anilinium hexafluoroantimonate; and, N,N-dimethyl-N-(p-methoxybenzyl)anilinium triflate.

### c) Electrically Conductive Particles

The composition of the present invention comprises electrically conductive particles. The composition may, for instance, contain from 40 to 75 wt.% or from 45 to 70 wt.% of electrically conductive particles, based on the weight of the composition. In certain important embodiments, the electrically conductive particles should be included in the composition in an amount of from 45 to 65 wt.%, based on the total weight of the composition. Preferably the composition comprises from 47 to 63 wt.%, for example from 48 to 60 wt.% of electrically conductive particles, based on the total weight of the composition.

Where the quantity of the electrically conductive particles is below 40 wt.%, based on the weight of the composition, the composition might not provide the desired electrical conductivity. Conversely, where the quantity of the electrically conductive filler is above 75 wt.%, based on the weight of the composition, the composition may no longer be cost effective and may possess a deleterious overall weight.

Broadly, there is no particular intention to limit the shape of the particles employed as electrically conductive fillers: particles that are acicular, spherical, ellipsoidal, cylindrical, bead-like, cubic or platelet-like may be used alone or in combination. The electrically conductive filler may be for example a mixture of spherical particles and flake particles. Moreover, it is envisaged that agglomerates of more than one particle type may be used.

Equally, there is no particular intention to limit the size of the particles employed as conductive fillers. However, such electrically conductive particles will conventionally have an average volume particle size, as measured by laser diffraction / scattering methods, of from 300 nm to 50 µm, for example from 500 nm to 40 µm or from 500 nm to 30 µm. In the aforementioned measurement method, the particle size is measured by particle size analyser and the particle shape is analysed by scanning electron microscope. In short, scattered laser lights from the particles are detected an array of detectors. Theoretical calculation is carried out to fit the measured distribution of scattered light intensity. During the fitting process the particle size distribution is deduced and *inter alia* D10, D50 and D90 values are calculated accordingly.

For surety, it is noted that suitable electrically conductive particles for use in the present invention may be a mixture of particles having a small particle size and particles having a larger particle size.

In an independent characterization of the particles, which may or may not compliment the aforementioned particle size distribution, it is preferred that the electrically conductive particles have a tap density from 0.5 to 6.0 g/cm³, preferably from 0.5 to 5.5 g/cm³ and more preferably from 0.5 to 5.0 g/cm³ as determined in accordance to ISO 3953 using a 25 cm³ graduated glass cylinder. The principle of the method specified is tapping a specified amount of powder in a container by means of a tapping apparatus until no further decrease in the volume of the powder takes place. The mass of the powder divided by its volume after the test gives its tap density.

Suitable electrically conductive particles are selected from the group consisting of: silver; nickel; carbon; carbon black; graphite; graphene; copper; gold; platinum; aluminium; iron; zinc; cobalt; lead; tin alloys; silver coated nickel; silver coated copper; silver coated graphite; silver coated polymers, for example silver coated acrylic polymers and / or silver coated silicone based polymers; silver coated aluminium; silver coated glass; silver coated carbon; silver coated boron nitride; silver coated aluminium oxide; silver coated aluminium hydroxide; nickel coated graphite; and, mixtures thereof.

Preferably electrically conductive filler is selected from the group consisting of: silver; carbon black; graphite; graphene; copper; silver coated nickel; silver coated copper; silver coated graphite; silver coated polymers; silver coated aluminium; silver coated glass; silver coated carbon; silver coated boron nitride; silver coated aluminium oxide; silver coated aluminium hydroxide; nickel coated graphite; and, mixtures thereof.

More preferably, the electrically conductive particles are selected from the group consisting of: silver, silver coated copper; silver coated graphite; silver coated polymers; silver coated aluminium; silver coated glass; and, mixtures thereof. Silver is particularly preferred because of its good electrical performance. Conversely, silver coated particles might gain preference because of their lower cost as compared to silver *per se.* However, in such silver coated or silver plated particles, the silver coating or plating should substantially and preferably wholly coat the underlying particulate material. Alternatively or additional to that requirement, the quantity of silver in the silver coated particle should preferably be from 10 to 70 wt.%, for example from 10 to 65 or 60 wt.% based on the total weight of the electrically conductive particles.

By way of illustration only, suitable commercially available electrically conductive particles for use in the present invention include, but are not limited to: AA3462, AA-5124, AA-192N, C-1284P, C-0083P and P543-14 silver particles, available from Metalor; KP84, KP74 and KP29 silver particles, available from Ames Goldsmidth; CGF-DAB-121B silver coated copper particles, available from Dowa; AgCu0810 or AgCu0305 silver coated copper particles, available from Ames Goldsmidth; CONDUCT-O-FIL^{™} SG15F35 silver coated glass, available from Potters Industries Inc.; the silver coated polymer Spherica^{™} Ag-30-01 , Spherica^{™} Ag-10-01 and Spherica^{™} Ag-4-01 available from Conpart AS; silver coated graphite available as P594-5 from Metalor; and, silver coated aluminium available as CONDUCT-O-FIL^{™} SA325S20 from Potters Industries Inc.

### d) Inorganic Particles

The composition of the present invention comprises d) inorganic particles selected from the group consisting of barium sulphate (BaSO₄), magnesium hydroxide (Mg(OH)₂), aluminium hydroxide (Al(OH)₃), and mixtures thereof. The composition may, for instance, contain from 0.5 to 10 wt.%, based on the weight of the composition, of said particles. Preferably the composition comprises from 1.0 to 8 wt.%, more preferably from 1.75 to 6.0 wt.% of said particles, based on the weight of the composition.

Broadly, there is no particular intention to limit the shape of the inorganic particles d): particles that are acicular, spherical, ellipsoidal, cylindrical, bead-like, cubic or platelet-like may be used alone or in combination. Moreover, it is envisaged that agglomerates of more than one particle type may be used. Equally, there is no particular intention to limit the size of the inorganic particles d) employed. However, such particles will conventionally have an average volume particle size, as measured by laser diffraction / scattering methods, of from 0.1 to 500 µm, for example from 1 to 250 µm.

By way of illustration only, suitable commercially available particulate inorganic materials include: Blanc Fixe N, available from Solvay; Bariace^{™} D-20, D-21 and D-34, barium sulphate available from Sakai Chemical; Martinal^{™} OL-104-IO, aluminium trihydroxide available from Martinwerke; and, Magnifine^{™} H10 magnesium dihydroxide, available from Albemarle.

### Additives and Adjunct Ingredients

Said compositions obtained in the present invention will typically further comprise adjuvants and additives that can impart improved properties to these compositions. Included among such adjuvants and additives are: plasticizers; stabilizers including UV stabilizers; non-epoxy functional flexibilizers; tougheners; adhesion promoters; conductivity promoters; anti-bleed agents; rheological adjuvants; wetting agents; surfactants;; antioxidants; reactive diluents; drying agents; fungicides; flame retardants; color pigments or color pastes; and / or optionally also, to a small extent, non-reactive diluents.

Such adjuvants and additives can be used in such combination and proportions as desired, provided they do not adversely affect the nature and essential properties of the composition. While exceptions may exist in some cases, these adjuvants and additives should not *in toto* comprise more than 20 wt.% of the total composition and preferably should not comprise more than 15 wt.% or more than 10 wt.% of the composition.

As noted above, the compositions of the present invention may include a non-epoxy functional flexibilizer to moderate one or both of the viscosity of the uncured resin and the cross-link density of the cured resin and so impart desirable mechanical properties to that cured composition, such as flexibility and thermal shock resistance especially when such compositions can experience temperature excursions below -40°C. When so included for these purposes, said flexibilizers should not exceed 25 wt.% based on the weight of part a) of the composition.

As suitable flexibilizers mention may be made of: polyol compounds bearing long aliphatic groups, such as ε-caprolactone triol available as TONE 0301, 0305, 0310 from Union Carbide Corporation; phenoxy functional modifiers; polysulfones, such as those available available under the product names UDEL and RADEL from BP-Amoco Chemical; polyetherimides, such as those available under the product name ULTEM from General Electric Plastics; polyamideimides; poly(arylene ethers); polyesters; polyarylates; polycarbonates; and, polyurethanes. Conventionally, the molecular weight (Mn) of these flexibilizers should range from 400 to 20,000 daltons, preferably from 500 to 5000 daltons.

A *"plasticizer"* for the purposes of this invention is a substance that decreases the viscosity of the composition and thus facilitates its processability. Herein the plasticizer may constitute up to 10 wt.% or up to 5 wt.%, based on the total weight of the composition, and is preferably selected from the group consisting of: diurethanes; ethers of monofunctional, linear or branched C₄-C₁₆ alcohols, such as Cetiol OE (obtainable from Cognis Deutschland GmbH, Düsseldorf); esters of abietic acid, butyric acid, thiobutyric acid, acetic acid, propionic acid esters and citric acid; esters based on nitrocellulose and polyvinyl acetate; fatty acid esters; dicarboxylic acid esters; esters of OH-group-carrying or epoxidized fatty acids; glycolic acid esters; benzoic acid esters; phosphoric acid esters; sulfonic acid esters; trimellitic acid esters; polyether plasticizers, such as end-capped polyethylene or polypropylene glycols; polystyrene; hydrocarbon plasticizers; chlorinated paraffin; and, mixtures thereof. It is noted that, in principle, phthalic acid esters can be used as the plasticizer but these are not preferred due to their toxicological potential.

*"Stabilizers"* for purposes of this invention are to be understood as antioxidants, UV stabilizers, thermal stabilizers or hydrolysis stabilizers. Herein stabilizers may constitute *in toto* up to 10 wt.% or up to 5 wt.%, based on the total weight of the composition. Standard commercial examples of stabilizers suitable for use herein include: sterically hindered phenols; thioethers; benzotriazoles; benzophenones; benzoates; cyanoacrylates; acrylates; amines of the hindered amine light stabilizer (HALS) type; phosphorus; sulfur; and, mixtures thereof.

The presence of tougheners in an amount up to 5 wt.%, based on the weight of the composition, can enhance the durability of the curable composition. Good durability has been achieved, in particular, here the composition of the present invention comprises at least one toughener selected from: epoxy-elastomer adducts; and, toughening rubber in the form of core-shell particles dispersed in the matrix polymer.

Elastomer-containing adducts may be used individually or a combination of two or more particular adducts might be used. Moreover, each adduct may independently be selected from solid adducts or liquid adducts at room temperature. Typically, useful adducts will be characterized by a ratio by weight of epoxy to elastomer of from 1:5 to 5:1, for example from 1:3 to 3:1. And an instructive reference regarding suitable epoxy / elastomer adducts is US Patent Publication 2004/0204551. Moreover, exemplary commercial epoxy/elastomer adducts for use herein include but are not limited to: HYPDX RK8-4 commercially available from CVC Chemical; and, B-Tough A3 available from Croda Europe Limited.

The term *"core shell rubber"* or CSR is being employed in accordance with its standard meaning in the art as denoting a rubber particle core formed by a polymer comprising an elastomeric or rubbery polymer as a main ingredient and a shell layer formed by a polymer which is graft polymerized onto the core. The shell layer partially or entirely covers the surface of the rubber particle core in the graft polymerization process. By weight, the core should constitute at least 50 wt.% of the core-shell rubber particle.

The polymeric material of the core should have a glass transition temperature (T_{g}) of no greater than 0°C and preferably a glass transition temperature (T_{g}) of -20°C or lower, more preferably -40°C or lower and even more preferably -60°C or lower. The polymer of the shell is non-elastomeric, thermoplastic or thermoset polymer having a glass transition temperature (T_{g}) of greater than room temperature, preferably greater than 30°C and more preferably greater than 50°C.

Without intention to limit the invention, the core may be comprised of: a diene homopolymer, for example, a homopolymer of butadiene or isoprene; a diene copolymer, for example a copolymer of butadiene or isoprene with one or more ethylenically unsaturated monomers, such as vinyl aromatic monomers, (meth)acrylonitrile or (meth)acrylates; polymers based on (meth)acrylic acid ester monomers, such as polybutylacrylate; and, polysiloxane elastomers such as polydimethylsiloxane and crosslinked polydimethylsiloxane.

Similarly without intention to limit the present invention, the shell may be comprised of a polymer or copolymer of one or more monomers selected from: (meth)acrylates, such as methyl methacrylate; vinyl aromatic monomers, such as styrene; vinyl cyanides, such as acrylonitrile; unsaturated acids and anhydrides, such as acrylic acid; and, (meth)acrylamides. The polymer or copolymer used in the shell may possess acid groups that are cross-linked ionically through metal carboxylate formation, in particular through forming salts of divalent metal cations. The shell polymer or copolymer may also be covalently cross-linked by monomers having two or more double bonds per molecule.

It is preferred that any included core-shell rubber particles have an average particle size (d50) of from 10nm to 300nm, for example from 50 nm to 250 nm: said particle size refers to the diameter or largest dimension of a particle in a distribution of particles and is measured via dynamic light scattering. For completeness, the present application does not preclude the presence of two or more types of core shell rubber (CSR) particles with different particle size distributions in the composition to provide a balance of key properties of the resultant cured product, including shear strength, peel strength and resin fracture toughness.

The core-shell rubber may be selected from commercially available products, examples of which include: Paraloid EXL 2650A, EXL 2655 and EXL2691 A, available from The Dow Chemical Company; Clearstrength^{®} XT100, available from Arkema Inc.; the Kane Ace^{®} MX series available from Kaneka Corporation, and in particular MX-120, MX-125, MX-130, MX-136, MX-551, MX-553; and, METABLEN SX-006 available from Mitsubishi Rayon.

An adhesion promoter may be added to the composition to improve the adhesion of the epoxy resin to a substrate. Adhesion promoters may function by forming a new layer at the interface which binds strongly to both the substrate and the coating. The resultant interfacial region may also be more resistant to chemical attack from the environment.

The selection of adhesion promoter may be determined by the type of surface to which the composition will be applied. That said, the most common commercial adhesion promoters are organosilanes of which certain epoxy functional organosilanes types have been mentioned hereinbefore. Further types of adhesion promoter which may find utility herein include: organometallic compounds such as titanates and zirconates, of which specific examples include isopropyl tri(N-ethylaminoethylamino)titanate, tetraisopropyl di(dioctylphosphito)titanate, neoalkoxytrisneodecanoyl zirconate and zirconium propionate; dihydric phenolic compounds such as catechol and thiodiphenol; hydroxyl amines such as tris(hydroxymethyl) aminomethane; polyhydric phenols such as pyrogallol, gallic acid, or tannic acid; and, plastisols, which are suspensions of polyvinyl chloride particles in a plasticizer.

As will be recognized by the skilled artisan, the amount of rheological adjuvants, reactive diluents and non-reactive diluents in the composition is determinative of the viscosity of the electrically conductive composition and can thus be moderated dependent upon the selected method of application of the composition. The viscosity tolerated for stencil or screen printing may, for instance, be slightly higher than the viscosity needed in a dispensing method. That aside, if the viscosity of the composition is too high - for instance the viscosity at 25°C is above 100 Pa.s as measured by rheometer at 15s⁻¹ - the application of the electrically conductive adhesive composition in any high speed process will become problematic.

### METHODS AND APPLICATIONS

To form a composition, the above described parts are brought together and mixed. It is important that the mixing homogenously distributes the ionic constituent - part b) - within the adhesive composition. As is known in the art, to form one component (1K) curable compositions, the elements of the composition are brought together and homogeneously mixed under conditions which inhibit or prevent the reactive components from reacting: such conditions would be readily comprehended by the skilled artisan. As such, it will often be preferred that the curative elements are not mixed by hand but are instead mixed by machine - a static or dynamic mixer, for example - in pre-determined amounts under anhydrous conditions without intentional heating or photo-irradiation.

In accordance with the broadest process aspects of the present invention, the above described compositions are applied to a substrate and then cured *in situ.* Prior to applying the compositions, it is often advisable to pre-treat the relevant surfaces to remove foreign matter there from: this step can, if applicable, facilitate the subsequent adhesion of the compositions thereto. Such treatments are known in the art and can be performed in a single or multi-stage manner constituted by, for instance, the use of one or more of: an etching treatment with an acid suitable for the substrate and optionally an oxidizing agent; sonication; plasma treatment, including chemical plasma treatment, corona treatment, atmospheric plasma treatment and flame plasma treatment; immersion in a waterborne alkaline degreasing bath; treatment with a waterborne cleaning emulsion; treatment with a cleaning solvent, such as carbon tetrachloride or trichloroethylene; and, water rinsing, preferably with de-ionized or de-mineralized water. In those instances where a waterborne alkaline degreasing bath is used, any of the degreasing agent remaining on the surface should desirably be removed by rinsing the substrate surface with de-ionized or de-mineralized water.

In some embodiments, the adhesion of the coating compositions of the present invention to the preferably pre-treated substrate may be facilitated by the application of a primer thereto. Whilst the skilled artisan will be able to select an appropriate primer, instructive references for the choice of primer include but are not limited to: US Patent No. 3,671,483; US Patent No. 4,681,636; US Patent No. 4,749,741; US Patent No. 4,147,685; and, US Patent No. 6,231,990.

The electrically conductive compositions are then applied to the preferably pre-treated, optionally primed surfaces of the substrate by conventional application methods such as: contact dispensing, including time/pressure dispensing (TPD), semi-positive displacement dispensing and true-positive displacement dispensing; non-contact jet dispensing; non-contact dynamic drop dispensing; and, printing methods. A preference may be noted for the application of the compositions by printing and, in particular, by screen or stencil printing.

It is recommended that the compositions be applied to a surface at a wet thickness of from 10 to 5000 µm, for example from 50 to 2500 µm. The application of thinner features within this range is more economical and provides for a reduced likelihood of deleterious thick cured regions. However, great control must be exercised in applying thinner coatings so as to avoid the formation of discontinuous cured films or linear features.

The curing of the applied compositions of the invention typically occurs at temperatures in the range of from 30°C to 200°C, preferably from 30°C to 180°C, and in particular from 40°C to 160°C. The temperature that is suitable depends on the specific compounds present and the desired curing rate and can be determined in the individual case by the skilled artisan, using simple preliminary tests if necessary. Of course, curing at lower temperatures within the aforementioned ranges is advantageous as it obviates the requirement to substantially heat or cool the mixture from the usually prevailing ambient temperature. Where applicable, however, the temperature of the mixture formed from the respective elements of the composition may be raised above the mixing temperature and / or the application temperature using conventional means including microwave induction.

In an embodiment, the electrically conductive adhesive composition as defined hereinabove may be applied to at least one of a solar cell or an electrically conductive ribbon (5), said ribbon (5) and said cell are contacted, optionally under pressure, and the electrically conductive composition is cured. By this process, an electrically conductive ribbon may be used to connect two or more solar cells, thereby forming a solar module.

In an embodiment, the present invention provides a method of making a shingled solar module, which method comprises: i) assembling a plurality of rectangular silicon solar cells arranged in line with end portions on long sides of adjacent rectangular silicon solar cells overlapping in a shingled manner; and, ii) at least partially curing an electrically conductive adhesive composition as defined herein above, which composition is disposed between the overlapping end portions of adjacent rectangular silicon solar cells, thereby bonding adjacent overlapping rectangular silicon solar cells to each other and electrically connecting them in series. The step of curing may be effected by the application of heat and, optionally, pressure to the overlapping rectangular silicon solar cells.

The plurality of rectangular silicon solar cells provided in step i) of the above embodiment may be obtained from a so-called super cell. Scribe lines, which define the plurality of rectangular cells, are created on the super cell using a laser and the cells are then separated along those scribe lines. Whilst the cells may be separated by cutting or dicing, in a further illustrative separation process, vacuum is applied between the bottom surfaces of the super cell and a curved supporting surface to flex the super cell against the curved supporting surface and thereby cleave the one or more silicon solar cells along the scribe lines. It is considered that the electrically conductive adhesive might be applied to the super cell in regions adjacent to the scribe lines prior to the separation of the individual silicon cells.

As noted in step ii) of this method, it may be feasible to form an intermediate structure through only partial curing the electrically conductive composition. However, where the module is so-formed by partially curing the adhesive composition, the method will comprise the step of completing the curing of the electrically conductive bonding material, thought the application of heat and, optionally, pressure to intermediate structure.

The following examples are illustrative of the present invention and are not intended to limit the scope of the invention in any way.

### EXAMPLES

The following materials and abbreviations for said materials were employed in the Examples:

| | |
|---|---|
| DER 331: | Liquid Epoxy Resin having an epoxy equivalent weight of 182-192 g/eq., reaction product of epichlorohydrin and bisphenol A, available from Olin. |
| Celloxide 2021 P: | Cycloaliphatic epoxy resin having an epoxy equivalent weight of 131 g/eq, available from Daicel. |
| Kane Ace MX-551: | 25% core-shell rubber in epoxy resin having an epoxy equivalent weight of 187 g/eq, available from Kaneka. |
| HDK H13L: | Pyrogenic silica, available from Wacker. |
| Cab-o-sil TS720: | Fumed silica, available from Cabot Corporation. |
| Cab-o-sil M5: | Fumed silica, available from Cabot Corporation. |
| Aerosil R202: | Surface treated fumed silica, available from Evonik Industries. |
| Adeka EP49-1 0N: | Bisphenol A-epichlorohydrin epoxy resin, neopentyl glycol ether, said product having an epoxy equivalent weight of 225 g/eq available from Adeka. |
| PEG 400: | Polyethyleneglycol (Mw 400 daltons) available from Fluka. |
| Heloxy Modifier 71: | Low viscosity aliphatic epoxy ester resin, available from Miller-Stevenson. |
| K-Pure CXC 1612: | Antimony hexafluoride based catalyst, available from King Industries. |
| Eternacoll OXBP: | 4,4-bis((3-ethyl-3-oxetanyl)methyl)biphenyl, available from UBE. |
| Dynol 980 Surfactant: | Siloxane surfactant, available from Air Products. |
| Polartherm PT110: | Boron nitride filler, available from General Electric. |
| KP84X: | Silver particles, available from Ames Goldsmith. |
| FA-SAB-617: | Silver particles, available from Dowa. |
| AA3642W: | Silver particles, available from Metalor. |
| EA23826 | Silver particles, available from Metalor. |
| SA0201: | Silver particles, available from Metalor. |
| P596-33: | Silver particles, available from Metalor. |
| Blanc Fixe N: | Barium sulphate particles, available from Solvay. |
| Bariace D-34 | Barium sulphate particles, available from Sakai Chemical. |
| Bariace D-21 | Barium sulphate particles, available from Sakai Chemical. |
| Bariace D-20 | Barium sulphate particles, available from Sakai Chemical. |
| Martinal OL-104-IO | Aluminium trihydroxide, available from Martinwerke. |
| Magnifine H10 | Magnesium dihydroxide, available from Albemarle. |
| Dynasylan^{®} Glymo: | 3-glycidyloxypropyltrimethoxysilane having an epoxy equivalent weight of 236 g/eq, available from Evonik Resource Efficiency GmbH. |
| Efka RM 1920: | Hydrogenated castor oil, thixotropic agent available from Azelis Americas. |
| Efka RM 1900: | Modified hydrogenated castor oil, rheology modifier available from Azelis Americas. |
| Cabot GPX 801: | Carbon nano-structured material, available from Cabot Corporation. |

The following Test Methods were employed in the Examples:

### i) Viscosity:

This was measured at 25°C on a Rheometer from TA Instruments Rheometer HR-1 or Q-2000 using a plate-plate geometry with a 2 cm in diameter plate at a 200 micron gap and shear rates of 1.5 s⁻¹ and / or 15 s⁻¹. Viscosity units are reported in Pa.s. Where given Shear Thinning Index is determined by dividing apparent viscosity at a shear rate of 1.5 s⁻¹ by apparent viscosity at a shear rate of 15 s⁻1

### ii) Volume Resistivity (VR)

Samples were prepared for the compositions according to the formulations below and deposited on a glass plate by drawing down a strip of material onto the surface of a glass slide with strip dimensions of 5 cm in length, 5 mm in width and 50 micron in thickness. The compositions were cured and dried according to the requirements for the resin used. The glass plates were cooled to room temperature, before measurement of resistance (ohm) using a Keithley 2010 Multimeter and a 4-point resistance probe. Volume resistivity (Ohm.cm) was calculated from equation: VR = (width of the sample (cm) x thickness of the sample (cm) x Resistance (Ohm)) / length of the sample (cm).

### iii) Glass Transition Temperature (Tg)

Glass transition temperature of epoxy resin - which had been cured and dried according to the requirements of the resin used - was determined by differential scanning calorimetry (DSC). Differential scanning calorimetry was run on a DuPont Model 910 DSC from -50 to 250° C at a ramp speed of 10° C per minute.

### Example 1

The Formulations 1a) to 1f) described in Table 1 herein below were prepared by homogenizing the stated ingredients using a centrifuge mixer. The formulations were then stored in an oven at 40°C.

**Table 1**

| **Ingredient** | **1a) Wt. (g)** | **1b) Wt. (g)** | **1c) Wt. (g)** | **1d) Wt. (g)** | **1e) Wt. (g)** | **1f) Wt. (g)** |
|---|---|---|---|---|---|---|
| Celloxide 2021P | 89.10 | 14.85 | 14.85 | 14.85 | 14.85 | 14.85 |
| K-Pure CXC 1612 | 0.90 | 0.15 | 0.15 | 0.15 | 0.15 | 0.15 |
| HDK H13L | | 0.60 | | | | |
| Aerosil R202 | | | 0.60 | | | |
| Cab-o-sil TS720 | | | | 0.60 | | |
| Cab-o-sil M5 | | | | | 0.60 | |
| Blanc Fixe N | | | | | | 0.60 |

After less than 24 hours all samples with the exception of 1f - containing barium sulfate - were completely hardened. Sample 1f) showed no discernible change even after 5 days.

### Example 2

The Formulations 2a) to 2 described in Table 2 herein below was homogenized using a centrifuge mixer and then stored in an oven at 23°C.

**Table 2**

| **Ingredient** | **2a) Wt. (%)** | **2b) Wt. (%)** | **2c) Wt. (%)** | **2d) Wt. (%)** |
|---|---|---|---|---|
| DER 331 | 33 | 33 | 33 | 29 |
| Heloxy Modifier 71 | 9 | 9 | 9 | 8 |
| K-Pure CXC 1612 | 3 | 3 | 3 | 3 |
| Blanc Fix N | 5 | 5 | 5 | 5 |
| AA3642W | 50 | | | |
| EA23826 | | 50 | | |
| SA0201 | | | 50 | |
| P596-33 | | | | 55 |

The viscosities of the Formulations 2a) to 2d) were each determined initially and after storage for 1, 2 and 3 months at room temperature. The results are illustrated in Table 3 herein below.

**Table 3**

| **Elapsed Time** | **Shear Rate (s⁻¹)** | **2a) Viscosity (Pa.s)** | **2b) Viscosity (Pa.s)** | **2c) Viscosity (Pa.s)** | **2d) Viscosity (Pa.s)** |
|---|---|---|---|---|---|
| 0 days | 1.5 | 58.1 | 24.2 | 32.5 | 82.3 |
| | 15 | 25.0 | 13.0 | 12.7 | 29.9 |
| 1 month | 1.5 | 50.5 | 15.8 | 29.6 | 77.5 |
| | 15 | 20.7 | 9.9 | 11.6 | 28.0 |
| 2 months | 1.5 | 58.6 | 19.3 | 35.7 | 73.5 |
| | 15 | 24.4 | 13.9 | 16.2 | 31.5 |
| 3 months | 1.5 | 60.7 | 26.1 | 41.1 | 109.0 |
| | 15 | 26.6 | 19.7 | 20.5 | 45.6 |

The above results demonstrate the preparation of adhesive compositions which are shelf-stable for a period of at least 3 months. Such compositions retain a viscosity after three months which is deleterious to their application to substrates by high speed processes such as dispensing and printing.

### Example 3

The Formulations 3a) to 3e) described in Table 4 herein below was homogenized using a centrifuge mixer and then stored in an oven at 23°C.

**Table 4**

| **Ingredient** | **3a) Wt. (g)** | **3b) Wt. (g)** | **3c) Wt. (g)** | **3d) Wt. (g)** | **3e) Wt. (g)** |
|---|---|---|---|---|---|
| DER 331 | 19.67 | 19.67 | 5.70 | 4.96 | 5.62 |
| Heloxy Modifier 71 | 7.07 | 7.07 | 2.02 | 2.76 | 2.02 |
| K-Pure CXC 1612 | 1.40 | 1.40 | 0.20 | 0.20 | 0.40 |
| KP84X | 19.25 | 19.25 | 5.50 | 5.50 | 5.50 |
| FASAB-617 | 19.25 | 19.25 | 5.50 | 5.50 | 5.50 |
| Blanc Fixe N | 1.75 | 1.75 | 1.00 | 1.00 | 0.50 |
| Dynasilan@ Glymo | 0.56 | 0.56 | 0.08 | 0.08 | 0.16 |
| Efka RM 1920 | 0.98 | 1.75 | | | |
| Cabot GPX 801 | | | | | 0.02 |

The formulations 3a) to 3e) were tested in accordance with the above mentioned protocols and the results are given in Table 5 herein below.

**Table 5**

| **Formulation** | **3a** | **3b** | **3c** | **3d** | **3e** |
|---|---|---|---|---|---|
| Tg (°C) | 110 | | | | |
| Viscosity at 1.5s⁻¹ shear rate (Pa.s) | 373 | 637 | 67.2 | 54.5 | 409 |
| Viscosity at 15s⁻¹ shear rate (Pa.s) | 64.4 | 76.1 | 25.7 | 20.4 | 74.1 |
| Shear Thinning Index | 5.79 | 8.37 | 2.62 | 2.87 | 5.52 |
| Volume Resistivity (10⁻⁴⁾ ohm.cm) | 7.65 | 5.35 | 5.63 | 125 | 7.74 |

In view of the foregoing description and examples, it will be apparent to those skilled in the art that equivalent modifications thereof can be made without departing from the scope of the claims.

## Claims

1. An electrically conductive one-component (1K) epoxy adhesive composition comprising
a) an epoxy resin;
b) at least one ionic constituent as a catalyst for epoxy homo-polymerization;
c) electrically conductive particles; and
d) inorganic particles selected from the group consisting of barium sulphate (BaSO₄), magnesium hydroxide (Mg(OH)₂), aluminium hydroxide (Al(OH)₃), and mixtures thereof.

2. The electrically conductive composition according to claim 1, wherein said epoxy resin is selected from the group consisting of: aliphatic epoxy resins; cycloaliphatic epoxy resins; epoxy novolac resins; bisphenol-A-epoxy resins; bisphenol-F-epoxy resins; bisphenol-A epichlorohydrin based epoxy resins; polyepoxides; reaction products of polyether-polyol with epichlorohydrin; epoxy silicone co-polymers; and, mixtures thereof,
wherein said epoxy resin is preferably selected from bisphenol-A epichlorohydrin based epoxy resin, aliphatic epoxy resin and mixtures thereof.

3. The electrically conductive composition according to claim 1 or claim 2, comprising said epoxy resin in an amount of from 20 to 55% by weight of the total weight of the composition, preferably from 25 to 40 wt.%, more preferably from 30 to 45 wt.% and even more preferably from 35 to 45 wt.%.

4. The electrically conductive composition according to any one of claims 1 to 3, wherein said at least one ionic constituent is selected from the group consisting of: ammonium salts; pyridinium salts; imidazolium salts; guadinium salts; oxazolium salts; thiazolium salts; iodinium salts; sulfonium salts; and, phosphonium salts,
wherein said at least one ionic constituent is preferably selected from the group consisting of: tetraalkyl ammonium tetrafluoro borate; tetraalkyl ammonium hexafluorophosphate; tetraalkyl ammonium hexafluoroantimonate; tetraalkyl ammonium triflate; trialkyl sulfonium tetrafluoro borate; trialkyl sulfonium hexafluorophosphate; trialkyl sulfonium hexafluoroantimonate; trialkyl sulfonium triflate; triaryl sulfonium tetrafluoro borate; triaryl sulfonium hexafluorophosphate; triaryl sulfonium hexafluoroantimonate; triaryl sulfonium triflate; dialkyl iodonium tetrafluoro borate; dialkyl iodonium hexafluorophosphate; dialkyl iodonium hexafluoroantimonate; dialkyl iodonium triflate; diaryl iodonium tetrafluoro borate; diaryl iodonium hexafluorophosphate; diaryl iodonium hexafluoroantimonate; diaryl iodonium triflate; benzylammonium tetrafluoro borate; benzylammonium hexafluoro phosphate; benzylammonium hexafluoroantimonate; benzylammonium triflate; p-methoxybenzylanilinium tetrafluoro borate; p-methoxybenzylanilinium hexafluoro phosphate; p-methoxybenzylanilinium hexafluoroantimonate; p-methoxybenzylanilinium triflate; and, mixtures thereof,
wherein said at least one ionic constituent is more preferably selected from the group consisting of: N,N-dimethyl-N-(p-methoxybenzyl)anilinium tetrafluoro borate; N,N-dimethyl-N-(p-methoxybenzyl)anilinium hexafluoroantimonate; N,N-dimethyl-N-(p-methoxybenzyl)anilinium triflate; and, mixtures thereof.

5. The electrically conductive composition according to any one of claims 1 to 4, comprising said at least one ionic constituent in an amount of from 0.5 to 5% by weight of the total weight of the composition, preferably from 0.6 to 4 wt.%, more preferably from 0.7 to 3.75 wt.% and even more preferably from 0.75 to 3.5 wt.%.

6. The electrically conductive composition according to any one of claims 1 to 5, wherein said electrically conductive particles are selected from the group consisting of: silver; nickel; carbon; carbon black; graphite; graphene; copper; gold; platinum; aluminium; iron; zinc; cobalt; lead; tin alloys; silver coated nickel; silver coated copper; silver coated graphite; silver coated polymers; silver coated aluminium; silver coated glass; silver coated carbon; silver coated boron nitride; silver coated aluminium oxide; silver coated aluminium hydroxide; nickel coated graphite; and, mixtures thereof,
wherein said electrically conductive particles are preferably selected from the group consisting of: silver; carbon black; graphite; graphene; copper; silver coated nickel; silver coated copper; silver coated graphite; silver coated polymers; silver coated aluminium; silver coated glass; silver coated carbon; silver coated boron nitride; silver coated aluminium oxide; silver coated aluminium hydroxide; nickel coated graphite; and, mixtures thereof,
wherein said electrically conductive particles are more preferably selected from the group consisting of: silver; silver coated copper; silver coated graphite; silver coated polymers; silver coated aluminium; silver coated glass; and, mixtures thereof,
wherein said electrically conductive particles are most preferably silver.

7. The electrically conductive composition according to any one of claims 1 to 6, comprising said electrically conductive particles in an amount of from 40 to 75% by weight of the total weight of the composition, preferably from 45 to 70 wt.%, more preferably from 47 to 63 wt.% and even more preferably from 48 to 60 wt.%.

8. The electrically conductive composition according to any one of claims 1 to 7, comprising said inorganic particles in an amount of from 0.5 to 10% by weight of the total weight of the composition, preferably from 1.0 to 8 wt.%, more preferably from 1.75 to 6.0 wt.%.

9. The electrically conductive composition according to any one of claims 1 to 8, wherein the activation temperature of the composition is at most 120°C, preferably from 80°C to 120°C and more preferably from 80°C to 110°C.

10. A cured product of the electrically conductive composition as defined in any one of claims 1 to 9.

11. Use of the electrically conductive composition as defined in any one of claims 1 to 9 or use of the cured product according to claim 10 on a solar cell and/or in a photovoltaic module, preferably as an interconnection material to connect solar cells into a photovoltaic module.

12. The use according to claim 11 as an interconnection material in the photovoltaic module, wherein the solar cells are shingled or in series connected with metal ribbons.

13. A photovoltaic module comprising
either a series-connected string of two or more solar cells in a shingle pattern having an electrically conductive bonding between said two or more solar cells, wherein said electrically conductive bonding is formed with an electrically conductive composition as defined in any one of claims 1 to 9 or with a cured product according to claim 10; or,
a series-connected string of two or more solar cells in a pattern having an electrically conductive ribbon connecting said two or more solar cells, wherein said electrically conductive ribbon is bonded to the cell with an electrically conductive composition as defined in any one of claims 1 to 9 or with a cured product according to claim 10.

14. The photovoltaic module according to claim 13, wherein said electrically conductive composition is applied by dispensing, jetting or printing.

## Patentansprüche

1. Elektrisch leitfähige Ein-Komponenten (1K) Epoxidklebstoffzusammensetzung, umfassend
a) ein Epoxidharz;
b) mindestens einen ionischen Bestandteil als Katalysator für die Epoxid-Homopolymerisation;
c) elektrisch leitfähige Partikel; und
d) anorganische Partikel, ausgewählt aus der Gruppe bestehend aus Bariumsulfat (BaSO₄), Magnesiumhydroxid (Mg(OH)₂), Aluminiumhydroxid (Al(OH)₃) und Mischungen davon.

2. Elektrisch leitfähige Zusammensetzung nach Anspruch 1, wobei das Epoxidharz aus der Gruppe ausgewählt ist bestehend aus: aliphatischen Epoxidharzen; cycloaliphatischen Epoxidharzen; Epoxid-Novolak-Harzen; Bisphenol-A-Epoxidharzen; Bisphenol-F-Epoxidharzen; Epoxidharzen auf Basis von Bisphenol-A-Epichlorhydrin; Polyepoxiden; Reaktionsprodukten von Polyetherpolyol mit Epichlorhydrin; Epoxid-Silikon-Copolymeren; und Gemischen davon,
wobei das Epoxidharz vorzugsweise aus Epoxidharz auf Basis von Bisphenol-A-Epichlorhydrin, aliphatischem Epoxidharz und Gemischen davon ausgewählt ist.

3. Elektrisch leitfähige Zusammensetzung nach Anspruch 1 oder Anspruch 2, umfassend das Epoxidharz in einer Menge von zu 20 bis 55 Gew.-% des Gesamtgewichts der Zusammensetzung, vorzugsweise von zu 25 bis 40 Gew.-%, weiter bevorzugt von zu 30 bis 45 Gew.-% und noch weiter bevorzugt von zu 35 bis 45 Gew.-%.

4. Elektrisch leitfähige Zusammensetzung nach einem der Ansprüche 1 bis 3, wobei der mindestens eine ionischen Bestandteil aus der Gruppe ausgewählt ist bestehend aus: Ammoniumsalzen; Pyridiniumsalzen; Imidazoliumsalzen; Guadiniumsalzen; Oxazoliumsalzen; Thiazoliumsalzen; lodiniumsalzen; Sulfoniumsalzen; und Phosphoniumsalzen,
wobei der mindestens eine ionische Bestandteil vorzugsweise aus der Gruppe ausgewählt ist bestehend aus Tetraalkylammoniumtetrafluoroborat; Tetraalkylammoniumhexafluorophosphat; Tetraalkylammoniumhexafluoroantimonat; Tetraalkylammoniumtriflat; Trialkylsulfoniumtetrafluorborat; Trialkylsulfoniumhexafluorophosphat; Trialkylsulfoniumhexafluoroantimonat; Trialkylsulfoniumtriflat; Triarylsulfoniumtetrafluorborat; Triarylsulfoniumhexafluorophosphat; Triarylsulfoniumhexafluoroantimonat; Triarylsulfoniumtriflat; Dialkyliodoniumtetrafluorborat; Dialkyliodoniumhexafluorophosphat; Dialkyliodoniumhexafluoroantimonat; Dialkyliodoniumtriflat; Diaryliodoniumtetrafluorborat; Diaryliodoniumhexafluorophosphat; Diaryliodoniumhexafluoroantimonat; Diaryliodoniumtriflat; Benzylammoniumtetrafluorborat; Benzylammoniumhexafluorophosphat; Benzylammoniumhexafluoroantimonat; Benzylammoniumtriflat; p-Methoxybenzylaniliniumtetrafluoroborat; p-Methoxybenzylaniliniumhexafluorophosphat; p-Methoxybenzylaniliniumhexafluoroantimonat; p-Methoxybenzylaniliniumtritiat; und Gemischen davon,
wobei der mindestens eine ionische Bestandteil weiter bevorzugt aus der Gruppe ausgewählt ist bestehend aus: N,N-Dimethyl-N-(p-methoxybenzyl)aniliniumtetrafluoroborat; N,N-Dimethyl-N-(p-methoxybenzyl)aniliniumhexafluoroantimonat; N,N-Dimethyl-N-(p-methoxybenzyl)aniliniumtritiat; und Gemischen davon.

5. Elektrisch leitfähige Zusammensetzung nach einem der Ansprüche 1 bis 4, umfassend den mindestens einen ionischen Bestandteil in einer Menge von zu 0,5 bis 5 Gew.-% des Gesamtgewichts der Zusammensetzung, vorzugsweise von zu 0,6 bis 4 Gew.-%, weiter bevorzugt von zu 0,7 bis 3,75 Gew.-% und noch weiter bevorzugt von zu 0,75 bis 3,5 Gew.-%.

6. Elektrisch leitfähige Zusammensetzung nach einem der Ansprüche 1 bis 5, wobei die elektrisch leitfähigen Partikel ausgewählt sind aus der Gruppe bestehend aus: Silber; Nickel; Kohlenstoff; Ruß; Graphit; Graphen; Kupfer; Gold; Platin; Aluminium; Eisen; Zink; Kobalt; Blei; Zinnlegierungen; silberbeschichtetem Nickel; silberbeschichtetem Kupfer; silberbeschichtetem Graphit; silberbeschichteten Polymeren; silberbeschichtetem Aluminium; silberbeschichtetem Glas; silberbeschichtetem Kohlenstoff; silberbeschichtetem Bornitrid; silberbeschichtetem Aluminiumoxid; silberbeschichtetem Aluminiumhydroxid; nickelbeschichtetem Graphit; und Gemischen davon,
wobei die elektrisch leitfähigen Partikel vorzugsweise aus der Gruppe ausgewählt sind bestehend aus: Silber; Ruß; Graphit; Graphen; Kupfer; silberbeschichtetem Nickel; silberbeschichtetem Kupfer; silberbeschichtetem Graphit; silberbeschichteten Polymeren; silberbeschichtetem Aluminium; silberbeschichtetem Glas; silberbeschichtetem Kohlenstoff; silberbeschichtetem Bornitrid; silberbeschichtetem Aluminiumoxid; silberbeschichtetem Aluminiumhydroxid; nickelbeschichtetem Graphit; und Gemischen davon,
wobei die elektrisch leitfähigen Partikel weiter bevorzugt aus der Gruppe ausgewählt sind bestehend aus: Silber; silberbeschichtetem Kupfer; silberbeschichtetem Graphit; silberbeschichteten Polymeren; silberbeschichtetem Aluminium; silberbeschichtetem Glas; und Gemischen davon, wobei die elektrisch leitfähigen Partikel am meisten bevorzugt Silber sind.

7. Elektrisch leitfähige Zusammensetzung nach einem der Ansprüche 1 bis 6, umfassend die elektrisch leitfähigen Partikel in einer Menge von zu 40 bis 75 Gew.-% des Gesamtgewichts der Zusammensetzung, vorzugsweise von zu 45 bis 70 Gew.-%, weiter bevorzugt von zu 47 bis 63 Gew.-% und noch weiter bevorzugt von zu 48 bis 60 Gew.-%.

8. Elektrisch leitfähige Zusammensetzung nach einem der Ansprüche 1 bis 7, umfassend die anorganischen Partikel in einer Menge von zu 0,5 bis 10 Gew.-% des Gesamtgewichts der Zusammensetzung, vorzugsweise von zu 1,0 bis 8 Gew.-%, weiter bevorzugt von 1,75 bis 6,0 Gew.-% umfasst.

9. Elektrisch leitfähige Zusammensetzung nach einem der Ansprüche 1 bis 8, wobei die Aktivierungstemperatur der Zusammensetzung höchstens 120 °C, vorzugsweise von 80 °C bis 120 °C und weiter bevorzugt von 80 °C bis 110 °C beträgt.

10. Gehärtetes Produkt der elektrisch leitfähigen Zusammensetzung nach einem der Ansprüche 1 bis 9.

11. Verwendung der elektrisch leitfähigen Zusammensetzung nach einem der Ansprüche 1 bis 9 oder Verwendung des gehärteten Produkts nach Anspruch 10 auf einer Solarzelle und/oder in einem Photovoltaikmodul, vorzugsweise als Verbindungsmaterial zum Verbinden von Solarzellen zu einem Photovoltaikmodul.

12. Verwendung nach Anspruch 11 als ein Verbindungsmaterial in dem Photovoltaikmodul, wobei die Solarzellen mit Metallbändern geschindelt oder in Reihe geschaltet sind.

13. Photovoltaikmodul umfassend
entweder einen in Reihe geschalteten Strang von zwei oder mehr Solarzellen in einem Schindelmuster, der eine elektrisch leitfähige Bindung zwischen den zwei oder mehr Solarzellen aufweist, wobei die elektrisch leitfähige Bindung mit einer elektrisch leitfähigen Zusammensetzung nach einem der Ansprüche 1 bis 9 oder mit einem gehärteten Produkt nach Anspruch 10 ausgebildet ist; oder einen in Reihe geschalteten Strang aus zwei oder mehr Solarzellen in einem Muster, bei dem ein elektrisch leitfähiges Band die zwei oder mehreren Solarzellen verbindet, wobei das elektrisch leitfähige Band mit einer elektrisch leitfähigen Zusammensetzung nach einem der Ansprüche 1 bis 9 oder mit einem gehärteten Produkt nach Anspruch 10 an die Zelle gebunden ist.

14. Photovoltaikmodul nach Anspruch 13, wobei die elektrisch leitfähige Zusammensetzung durch Verteilen, Ausstoßen oder Drucken aufgebracht wird.

## Revendications

1. Composition adhésive époxy à monocomposant électriquement conductrice comprenant
a) une résine époxy ;
b) au moins un constituant ionique comme catalyseur de l'homopolymérisation de l'époxy ;
c) des particules électriquement conductrices ; et
d) des particules inorganiques choisies dans le groupe constitué de sulfate de baryum (BaSO₄), hydroxyde de magnésium (Mg(OH)₂), hydroxyde d'aluminium (Al(OH)₃) et des mélanges ceux-ci.

2. Composition électriquement conductrice selon la revendication 1, dans laquelle ladite résine époxy est choisie dans le groupe constitué : de résines époxy aliphatiques ; de résines époxy cycloaliphatiques ; de résines époxy novolac ; de résines époxydes à base de bisphénol-A ; de résines époxydes à base de bisphénol-F ; de résines époxy à base d'épichlorhydrine de bisphénol-A ; de polyépoxydes ; de produits de réaction du polyéther-polyol avec l'épichlorhydrine ; de co-polymères époxy-silicone ; et, des mélanges de ceux-ci,
dans laquelle ladite résine époxy est de préférence choisie parmi les résines époxy à base d'épichlorhydrine de bisphénol-A, les résines époxy aliphatiques et des mélanges de ceux-ci.

3. Composition électriquement conductrice selon la revendication 1 ou la revendication 2, comprenant ladite résine d'époxy en une quantité allant de 20 à 55 % en poids du poids total de la composition, de préférence de 25 à 40 % en poids, plus préférablement allant de 30 à 45 % en poids et même plus préférablement allant de 35 à 45 % en poids.

4. Composition électriquement conductrice selon l'une quelconque des revendications 1 à 3, dans laquelle au moins un des constituants ioniques est choisi dans le groupe constitué : de sels d'ammonium ; de sels de pyridinium ; de sels d'imidazolium ; de sels de guadinium ; de sels d'oxazolium ; de sels de thiazolium ; de sels d'iodinium ; de sels de sulfonium ; et de sels de phosphonium,
dans laquelle ledit au moins un constituant ionique est de préférence choisi dans le groupe constitué : de borate de tétraalkyl ammonium tétrafluoro ; d'hexafluorophosphate d'ammonium tétraalkylique ; de tétraalkyl ammonium hexafluoroantimonate ; de triflate d'ammonium tétraalkylique ; de borate de trialkyl sulfonium tétrafluoro ; de hexafluorophosphate de trialkyl sulfonium ; de trialkyl sulfonium hexafluoroantimonate ; de triflate de trialkyl sulfonium ; de borate de triaryl sulfonium tétrafluoro ; d'hexafluorophosphate de triaryl sulfonium ; d'hexafluoroantimonate de triaryl sulfonium ; de triflate de triaryl sulfonium ; de borate de dialkyl iodonium tétrafluoro ; d'hexafluorophosphate d'iodonium de dialkyle ; de dialkyl iodonium hexafluoroantimonate ; de triflate d'iodonium de dialkyle ; de borate de diaryl iodonium tétrafluoro ; d'hexafluorophosphate de diaryl iodonium ; de diaryl iodonium hexafluoroantimonate ; de triflate d'iodonium diaryle ; de borate de benzylammonium et de tétrafluoro ; de phosphate de benzylammonium hexafluoré ; d'hexafluoroantimonate de benzylammonium ; de triflate de benzylammonium ; de borate de p-méthoxybenzylanilinium tétrafluoro ; de phosphate de p-méthoxybenzylanilinium hexafluoro ; de p-méthoxybenzylanilinium hexafluoroantimonate ; de tritiate de p-méthoxybenzylanilinium ; et, des mélanges de ceux-ci,
dans laquelle ledit au moins un constituant ionique est, de préférence, choisi dans le groupe constitué : de N,N-diméthyl-N-(p-méthoxybenzyl)anilinium tétrafluoro borate ; de N,N-diméthyl-N-(p-méthoxybenzyl)anilinium hexafluoroantimonate ; de N,N-diméthyl-N-(p-methoxybenzyl)anilinium tritiate ; et des mélanges de ceux-ci.

5. Composition électriquement conductrice selon l'une quelconque des revendications 1 à 4, comprenant ledit au moins un constituant ionique en une quantité allant de 0,5 à 5 % en poids du poids total de la composition, de préférence allant de 0,6 à 4 % en poids, plus préférablement allant de 0,7 à 3,75 % en poids et encore plus préférablement allant de 0,75 à 3,5 % en poids.

6. Composition électriquement conductrice selon l'une quelconque des revendications 1 à 5, dans laquelle lesdites particules conductrices d'électricité sont sélectionnées dans le groupe composé : d'argent ; de nickel ; de carbone ; de noir de carbone ; de graphite ; de graphène ; de cuivre ; d'or ; de platine ; d'aluminium ; de fer ; de zinc ; de cobalt ; de plomb ; d'alliages d'étain ; de nickel argenté ; de cuivre argenté ; de graphite recouvert d'argent ; de polymères recouverts d'argent ; d'aluminium argenté ; de verre à revêtement argenté ; de carbone argenté ; de nitrure de bore recouvert d'argent ; d'oxyde d'aluminium revêtu d'argent ; d'hydroxyde d'aluminium recouvert d'argent ; de graphite recouvert de nickel ; et, des mélanges de ceux-ci,
dans laquelle lesdites particules conductrices d'électricité sont de préférence choisies dans le groupe constitué : d'argent ; de noir de carbone ; de graphite ; de graphène ; du cuivre ; de nickel argenté ; de cuivre argenté ; de graphite recouvert d'argent ; de polymères recouverts d'argent ; d'aluminium argenté ; de verre à revêtement argenté ; de carbone argenté ; de nitrure de bore recouvert d'argent ; d'oxyde d'aluminium revêtu d'argent ; d'hydroxyde d'aluminium recouvert d'argent ; de graphite recouvert de nickel ; et, des mélanges de ceux-ci,
dans laquelle lesdites particules conductrices d'électricité sont de préférence choisies dans le groupe constitué : d'argent ; de cuivre argenté ; de graphite recouvert d'argent ; de polymères recouverts d'argent ; d'aluminium argenté ; de verre à revêtement argenté ; et de leurs mélanges,
dans laquelle les particules conductrices d'électricité sont de préférence de l'argent.

7. Composition électriquement conductrice selon l'une quelconque des revendications 1 à 6, comprenant lesdites particules électriquement conductrices en une quantité allant de 40 à 75 % en poids du poids total de la composition, de préférence allant de 45 à 70 % en poids, plus préférablement allant de 47 à 63 % en poids et encore plus préférablement de 48 à 60 % en poids.

8. Composition électriquement conductrice selon l'une quelconque des revendications 1 à 7, comprenant lesdites particules inorganiques en une quantité allant de 0,5 à 10 % en poids du poids total de la composition, de préférence allant de 1,0 à 8 % en poids, et encore plus préférablement allant de 1,75 à 6,0 % en poids.

9. Composition électriquement conductrice selon l'une des revendications 1 à 8, dans laquelle la température d'activation de la composition est au maximum de 120 °C, de préférence de 80 °C à 120 °C et plus préférablement de 80 °C à 110 °C.

10. Produit durci de la composition électriquement conductrice telle que définie dans l'une quelconque des revendications 1 à 9.

11. Utilisation de la composition électriquement conductrice telle que définie dans l'une quelconque des revendications 1 à 9 ou utilisation du produit durci selon la revendication 10 sur une cellule solaire et/ou dans un module photovoltaïque, de préférence comme matériau d'interconnexion pour connecter des cellules solaires dans un module photovoltaïque.

12. Utilisation selon la revendication 11, comme matériau d'interconnexion dans le module photovoltaïque, dans laquelle les cellules solaires sont bardées ou en série reliées par des rubans métalliques.

13. Module photovoltaïque comprenant
une chaîne montée en série de deux cellules solaires ou plus dans un motif de bardeaux ayant une liaison électriquement conductrice entre lesdites deux cellules solaires ou plus, dans lequel ladite liaison électriquement conductrice est formée avec une composition électriquement conductrice telle que décrite selon l'une quelconque des revendications 1 à 9 ou avec un produit durci selon la revendication 10 ; ou, une chaîne connectée en série de deux cellules solaires ou plus dans un motif ayant un ruban électriquement conducteur reliant lesdites deux cellules solaires ou plus, dans lequel ledit ruban électriquement conducteur est lié à la cellule avec une composition électriquement conductrice telle que définie dans l'une des revendications 1 à 9 ou avec un produit durci selon la revendication 10.

14. Module photovoltaïque selon la revendication 13, dans lequel ladite composition électriquement conductrice est appliquée par distribution, projection ou impression.
